(19) **Europäisches Patentamt / European Patent Office / Office européen des brevets**

(11) **EP 3 306 608 B1**

(12) **EUROPEAN PATENT SPECIFICATION**

(45) Date of publication and mention
of the grant of the patent:
**13.03.2019 Bulletin 2019/11**

(51) Int Cl.:
*G10L 25/69* (2013.01)          *G10L 25/18* (2013.01)
*H03G 5/00* (2006.01)

(21) Application number: **16192913.8**

(22) Date of filing: **07.10.2016**

(54) **ESTIMATING AUDIBILITY OF AUDIO SAMPLES**

SCHÄTZUNG DER VERNEHMBARKEIT VON TONPROBEN

ESTIMATION D'AUDIBILITÉ D'ÉCHANTILLONS AUDIO

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**11.04.2018 Bulletin 2018/15**

(73) Proprietor: **BMAT LICENSING, S.L.U.**
**08024 Barcelona (ES)**

(72) Inventors:
• **MOLINA, Emilio**
**08024 BARCELONA (ES)**

• **CANO, Pedro**
**08024 BARCELONA (ES)**
• **CIURANA, Alex**
**08024 BARCELONA (ES)**
• **LYDA, Johannes**
**08024 BARCELONA (ES)**

(74) Representative: **ZBM Patents - Zea, Barlocci &
Markvardsen**
**Plaza Catalunya, 1 2nd floor**
**08002 Barcelona (ES)**

(56) References cited:
**EP-A1- 2 579 247    US-A1- 2013 121 662**

EP 3 306 608 B1

**Description**

The present disclosure relates to methods for estimating audibility of audio samples in broadcasting media programs.

BACKGROUND

The use of audio samples, especially samples of music, in broadcast media programs is quite common and may have very different purposes. In some cases, types of audio, e.g. music, plays an important role in a show and it is clearly perceived in the foreground. However, in many other situations, such audio might be barely perceivable because it has very low volume or it may be masked by other sounds (e.g. speech). In such situations, music might not be audible enough to be taken into account for copyright purposes.

Since audio samples (e.g. music, as mentioned) in broadcast media programs are commonly mixed with other sounds (e.g. speech), measuring its audibility level is challenging. On the one hand, the relative power level of the audio sample within the audio mix is unknown a priori. The trivial solution to determine the relative power of the audio sample is to measure it in production stage, where the various tracks are still independent in the mixing desk. However, this measurement is not generally carried out in real-world broadcast production. An example of audibility measurement in a sound mix is provided in EP 2 579 247 A1.

It would be desirable to provide an alternative method to estimate audibility of audio samples in audio mixes of broadcast media programs.

SUMMARY

Methods are proposed to estimate the perceived audibility of audio samples in broadcast media programs. According to the proposed method, a rough time-frequency representation (e.g. a filter banks output) of two involved audios may be processed: a broadcast media program (that may comprise one or more audio mixes) and a time aligned, and gain adjusted audio sample. The audio sample needs to be time-aligned with the audio mix, and the power of the aligned audio sample needs to fit the power of the music within the audio mix.

One way to achieve this alignment may be to annotate time-alignment and power information in production stage, where tracks are not mixed yet; however, this is not usual in real-world scenarios. There are other ways, such as through audio fingerprinting techniques, to achieve optimal time alignment and gain adjustment.

Once these two time-frequency representations (in matrix form) are available, they may be subtracted term-by-term to generate a new matrix, hereinafter called difference matrix. This difference matrix typically has low magnitude in the time-frequency regions that have no overlapping sounds on top of the audio sample.

The difference matrix may then be processed using the absolute power of the audio sample in order to identify regions where it is not audible due to its low power (even if it is not masked). The result of this last process is an audibility matrix. This audibility matrix may then be processed in time intervals, of e.g. 0.5s, to generate an average curve indicating the audibility of music along time.

In a first aspect, a method to estimate the audibility of an audio sample in an audio mix of a broadcast media program according to independent claim 1 is proposed. The method comprises providing a representation matrix of an audio mix, the audio mix comprising the audio sample and additional audio; providing a representation matrix of the audio sample; subtracting the representation matrix of the audio sample from the representation matrix of the audio mix to generate a difference matrix; applying an audibility model to the difference matrix to generate an audibility matrix; determining an audibility level for each element of the audibility matrix; and averaging the determined audibility levels of the matrix to estimate the audibility of the audio sample.

This allows determining if an audio sample is audible in the audio mix. Thereafter, it is possible to decide if the audio sample may be accounted for copyright attribution purposes.

In some examples, the method may further comprise time alignment and gain adjustment between the representation matrix of the audio sample and the representation matrix of the audio mix. Aligning in time may comprise aligning in time using spectral peaks. The use of spectral peaks allows for simple, noise-robust and efficient audio matching, since it does not need to process the whole audio information, but only a few hundreds of peaks.

The gain adjustment may also be computed using spectral peaks, since they provide enough information to relate the power of the peaks in audio sample, and the power of the peaks in the mix.

In some examples, the representation matrix may be a low resolution time-frequency representation matrix (e.g. a filter banks output). This allows reducing the amount information to be processed, and to avoid imperceptible high resolution details to affect the final result.

In some examples, the audibility model may be an equal-loudness contour model, such as a Fletcher-Munson model. This allows for determining absolute audibility thresholds more precisely, since it takes into account psychoacoustics factors.

In some examples, the method may further comprise applying a psychoacoustic masking model to the audio mix to generate the representation matrix of the audio mix. This allows producing a more precise audibility value, since it takes into account masking effects that might reduce the actual audibility of certain frequencies.

In some examples, averaging may be carried out in time intervals to estimate the audibility of the audio sample in the audio mix at each time interval. This allows for determining portions of an audio sample that may be more audible and portions of the audio sample that may be less audible. Based on the determination, a percentage of copyright attribution may then take place for each time interval.

In some examples, the method may further comprise quantizing the estimated audibility to a predetermined number of audibility levels. For example, four audibility levels may be established and the audio sample or portions of the audio sample may be attributed to one of the four levels.

In some examples, the audio sample may be music and the additional audio may be speech. This is a typical scenario in broadcast media programs, such as talk shows or news programs, where music is played in the background of a discussion or presentation.

In some examples, the method may further comprise providing a broadcast media program and providing a cue sheet. The broadcast media program may comprise the audio mix and the cue sheet may comprise an indication of the start time and end time of the audio sample in the broadcast media program. This may be provided in post-production stage. The use of cue sheets allows automatizing the audio trimming to estimate the audibility of each individual audio sample.

In some examples, the audio mix may comprise a plurality of audio samples and additional audio. The method may then further comprise trimming the audio mix to isolate the part of the audio mix corresponding to one single audio sample. This may allow processing and estimating the audibility of each audio sample of the audio mix.

BRIEF DESCRIPTION OF THE DRAWINGS

Non-limiting examples of the present disclosure will be described in the following, with reference to the appended drawings, in which:

Figure 1 schematically illustrates a flow chart of a method of estimating the audibility of an audio sample in an audio mix of a broadcast media program according to an example;

Figure 2A schematically illustrates an audio signal with signal portions of varying audibility;

Fig. 2B schematically illustrates an audibility curve;

Fig. 3 schematically illustrates a flow chart of a method of estimating the audibility of an audio sample in an audio mix of a broadcast media program according to another example;

Fig. 4 schematically illustrates a flow chart of a method of estimating the audibility of an audio sample in an audio mix of a broadcast media program according to yet another example;

Fig. 5 schematically illustrates an automatic process of broadcast cue-sheets to estimate audibility of various audio samples according to an example.

DETAILED DESCRIPTION OF EXAMPLES

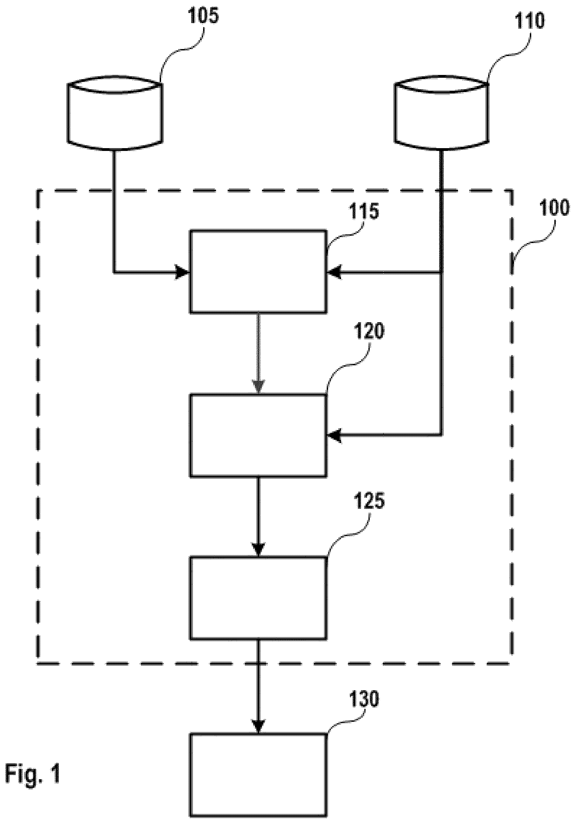

Figure 1 schematically illustrates a flow chart of a method of estimating the audibility of an audio sample in an audio mix of a broadcast media program according to an example. A time-frequency matrix representation of an audio mix may be provided in block 105. An aligned time-frequency matrix representation of an audio sample may be provided in block 110. The audio sample may be music or a song. It may be assumed that the audio mix comprises a copy of the audio sample along with other additional audio, e.g. speech. Then audibility estimation 100 may be performed. In block 115 the representation matrix of the audio sample may be subtracted from the representation matrix of the audio mix to generate a difference matrix. Once the difference matrix is generated, the information provided by the difference matrix may be used to avoid very low power regions (even if unmasked) to be considered as inaudible. For that purpose, an audibility model, e.g. Fletcher-Munson curves, which are based on psychoacoustic experiments, may be applied in block 120 to determine an absolute audibility threshold. It may provide an audibility matrix as output. Then in block 125 the various potentially audible time-frequency regions may be identified, thus providing an audibility curve 130.

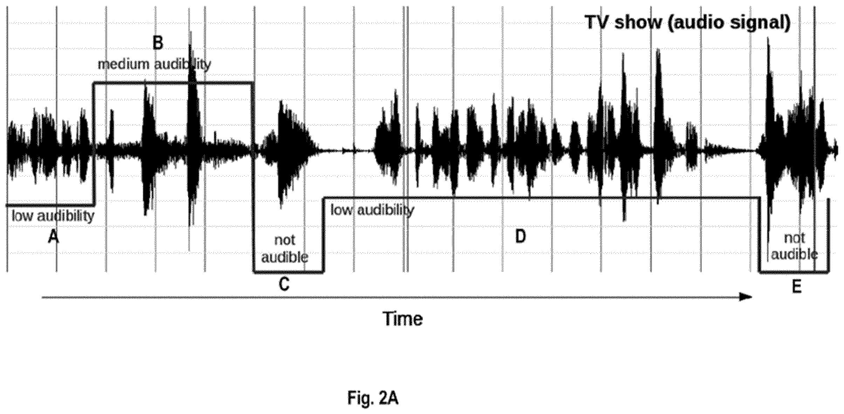

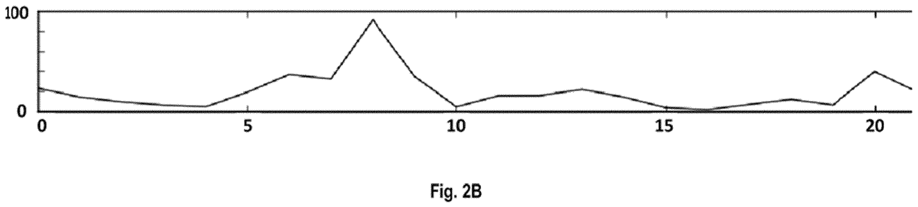

Figure 2A schematically illustrates an audio signal with signal portions of varying audibility. A first and a fourth regions A and D, respectively, may be characterised as a low audibility regions, a second region B as a medium audibility region and a third and a fifth regions C and E, respectively, as not audible. Fig. 2B schematically illustrates an audibility curve. The horizontal axis represents time and the vertical axis the percentage of audibility from 0% to 100%.

The average audibility may be computed by averaging the audibility curve. This average may then be quantized into e.g. four categories:

- Audibility between 0% and 10% : No audible
- Audibility between 10% and 30%: Low-audibility
- Audibility between 30% to 70% : Mid-audibility
- Audibility between 70% to 100%: High-audibility

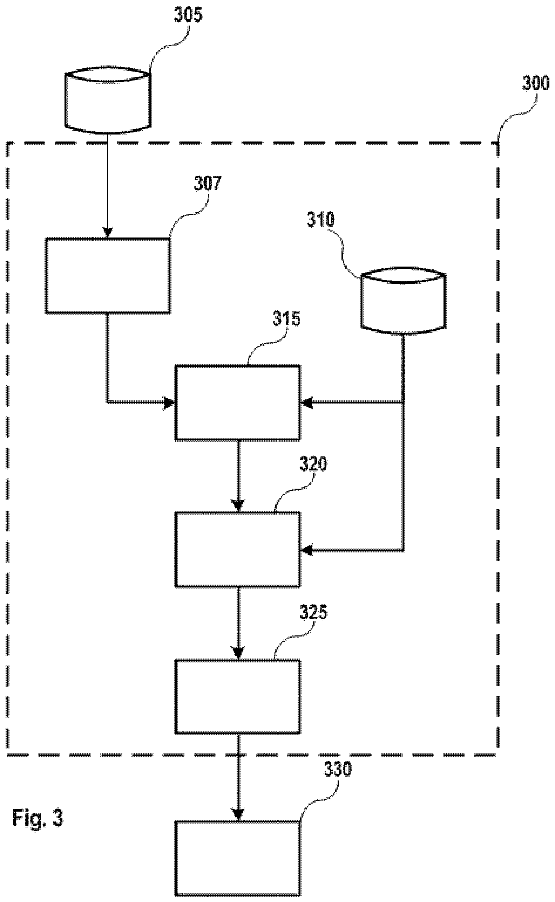

Fig. 3 schematically illustrates a flow chart of a method of estimating the audibility of an audio sample in an audio mix of a broadcast media program according to another example. In the example of Fig. 3 a psychoacoustic masking model may be used to process the time-frequency representation of the audio mix before the subtraction. Similarly to the example discussed with reference to Fig. 1, a time-frequency matrix representation of an audio mix may be provided in block 305. Then audibility estimation 300 may be performed. In block 307 a psychoacoustic masking model may be used to process the time-frequency representation of the audio mix. The masking model may identify the tonal and non-tonal components of the audio signal, and applies a masking function around each of them. The sum of all masking functions may determine the masking threshold, which may be concatenated frame-by-frame in order to create the time-frequency masking threshold in matrix form as specified, e.g. in the standard ISO/IEC 11172-3:1993. The result may be a time-frequency representation of the masking threshold. Any sound below this threshold may be considered to be masked, and therefore it may be considered inaudible. In the example of Fig. 3, the representation matrix of the audio mix is replaced by the time-frequency representation of the masking threshold of the mix. In this way, the audibility estimation may be improved for the cases where auditory masking is noticeable. In block 310 an aligned time-frequency matrix representation of an audio sample may be provided. The audio sample may be music or a song. Then in block 315 the representation matrix of the audio sample may be subtracted from the time-frequency masking threshold matrix of the audio mix to generate a difference matrix. Then, again, in a similar manner as the previous example, an audibility model may be applied in block 320 to determine an absolute audibility threshold. It may provide an audibility matrix as output. Then in block 325 the various potentially audible time-frequency regions may be identified in the audibility matrix. Then an audibility curve 330 may be generated.

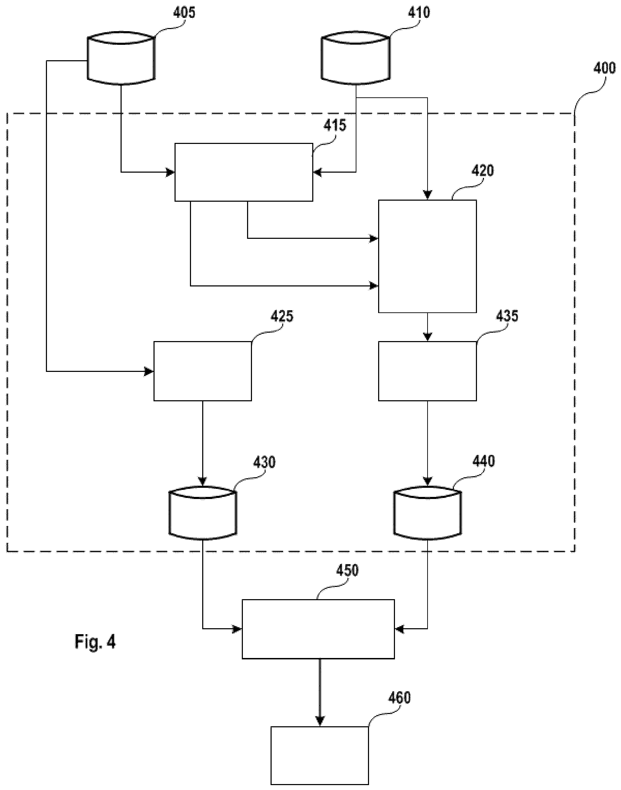

Fig. 4 schematically illustrates a flow chart of a method of estimating the audibility of an audio sample in an audio mix of a broadcast media program according to yet another example. In the example of Fig. 4 the spectral peaks (also called landmarks) are used to find the gain adjustment and time shifting of the audio sample in the audio mix. Such techniques are commonly applied in audio fingerprinting, and they allow finding the optimal match of a set of points between a query (i.e. the audio mix) and a reference (i.e. the audio sample). Any set of spectral peaks, or landmarks, able to summarize the original audio content may be used. In its simplest definition, the spectral peaks may be local maxima in the time-frequency representation (e.g. short-time Fourier transform, constant-Q transform, etc.). These spectral peaks may then be used to find the optimal alignment between two audios containing the same information (matching). The alignment may be performed by looking for peaks with same frequency in query and reference, and same relative time shifting. This matching information is stored as a list of common peaks. This information may then be used to compute the time alignment and the amplitude ratio between reference and query, where:

$$\text{Time alignment} = \text{Time location in query} - \text{Time location in reference};$$

and

$$\text{Amplitude ratio} = \text{Amplitude in query} / \text{Amplitude in reference}$$

This information may then be used to align in time, and to adjust the gain of the sample in order to sound like it sounds in the mix.

In Fig. 4, the audio mix is provided in block 405 and the audio sample in block 410. Then estimation of time alignment and relative power of the audio sample in the audio mix may be performed in block 400. In block 415 the two signals are time aligned using spectral peaks. Block 415 may provide the exact time position of the audio sample in the audio mix and the power of the audio sample in the mix. Then the vector of the audio sample signal, the exact time position of the audio sample in the audio mix and the power of the audio sample in the mix are provided to block 420 where a time shifted and gain adjusted vector audio signal is generated. In block 425, a time-frequency matrix representation 430 of the audio signal vector is generated. This is already time aligned from block 415. In parallel, in block 435 a time-frequency matrix representation 440 of the audio mix signal vector is generated. The two matrices are then provided to block 450 where audibility estimation may take place according to the examples provided herein and an audibility curve 460 may then be provided.

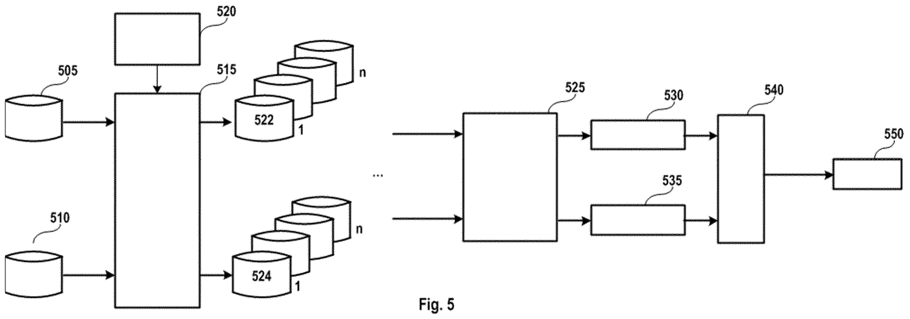

Fig. 5 schematically illustrates an automatic process of broadcast cue-sheets to estimate audibility of various audio samples according to an example. In block 505, the audio file of a broadcast media program may be provided as a long audio signal vector. In block 510, the audio files of the audio samples that may be present in the broadcast media program may be provided as an audio signal vector. In block 515 the cue-sheet may be provided. The vectors may be trimmed with the use of the cue-sheet in block 520. Trimming may generate a first set of audio mix signal vectors 522n and a second set of audio sample vectors 524n. The members of the sets may correspond to each other. For each pair of audio mix signal vector and audio sample signal vector, the process may continue in block 525 with the estimation of time alignment and relative power of the audio sample in the audio mix. Then in blocks 530 and 535 a time frequency representation matrix of the audio mix and of the audio sample, respectively, may be generated. Finally, in block 540 audibility estimation may take place using methods as disclosed herein to generate audibility curve 550.

Although only a number of examples have been disclosed herein, other alternatives, modifications, uses and/or equivalents thereof are possible. Furthermore, all possible combinations of the described examples are also covered. Thus, the scope of the present disclosure should not be limited by particular examples, but should be determined only by a fair reading of the claims that follow. If reference signs related to drawings are placed in parentheses in a claim, they are solely for attempting to increase the intelligibility of the claim, and shall not be construed as limiting the scope of the claim.

Further, although the examples described with reference to the drawings comprise computing apparatus/systems and processes performed in computing apparatus/systems, the invention also extends to computer programs, particularly computer programs on or in a carrier, adapted for putting the system into practice.

## Claims

1.    A method to estimate the audibility of an audio sample in an audio mix of a broadcast media program, comprising:

   providing representation matrix of an audio mix, the audio mix comprising the audio sample and additional audio;
   providing a representation matrix of the audio sample;
   subtracting the representation matrix of the audio sample from representation matrix of the audio mix to generate a difference matrix;
   applying an audibility model to the difference matrix to generate an audibility matrix;
   determining an audibility level for each element of the audibility matrix;
   averaging the determined audibility levels of the matrix to estimate the audibility of the audio sample.

2.    The method according to claim 1, further comprising time alignment between the representation matrix of the audio sample and the representation matrix of the audio mix.

3.    The method according to claim 2, wherein aligning in time comprises aligning in time using spectral peaks.

4.    The method according to any of claims 1 to 3, further comprising gain adjustment between the representation matrix of the audio sample and the representation matrix of the audio mix.

5.    The method according to any of claims 1 to 4, wherein the representation matrix is a low resolution time-frequency representation matrix.

6.    The method according to any of claims 1 to 5, wherein the audibility model is an equal-loudness contour model.

7.    The method according to any of claims 1 to 6, wherein the audibility model is a Fletcher-Munson model.

8.    The method according to any of claims 1 to 7, further comprising applying a psychoacoustic masking model to the audio mix to generate the representation matrix of the audio mix.

9.    The method according to any of claims 1 to 8, wherein averaging comprises averaging in time intervals to estimate the audibility of the audio sample in the audio mix at each time interval.

10. The method according to any of claims 1 to 9, further comprising quantizing the estimated audibility to a predetermined number of audibility levels.

11. The method according to any of claims 1 to 8, wherein the audio sample is music and the additional audio is speech.

12. The method according to any of claims 1 to 11, further comprising
providing a broadcast media program, the broadcast media program comprising the audio mix,
providing a cue sheet, the cue sheet comprising an indication of the start time and end time of the audio sample in the broadcast media program.

13. The method according to claim 12, wherein audio mix comprises a plurality of audio samples and additional audio.

14. The method according to claim 13, further comprising trimming the audio mix to isolate each audio sample.

15. The method according to claim 14, further comprising estimating the audibility of each audio sample of the broadcasting program.


**Patentansprüche**

1. Ein Verfahren zum Abschätzen der Vernehmbarkeit von einer Tonprobe in einer Tonmischung eines Rundfunkmedienprogramms, umfassend:

bereitstellen von einer Darstellungsmatrix einer Tonmischung, wobei die Tonmischung die Tonprobe und eine zusätzliche Tonaufnahme umfasst;
bereitstellen von einer Darstellungsmatrix der Tonprobe;
subtrahieren der Darstellungsmatrix der Tonprobe von der Darstellungsmatrix der Tonmischung, um eine Differenzmatrix zu erzeugen;
anwenden von einem Vernehmbarkeitsmodell auf die Differenzmatrix, um eine Vernehmbarkeitsmatrix zu erzeugen;
feststellen von einem Vernehmbarkeitsniveau für jedes Element der Vernehmbarkeitsmatrix;
berechnen des Durchschnitts der festgestellten Vernehmbarkeitsniveaus der Matrix, um die Vernehmbarkeit der Tonprobe abzuschätzen.

2. Das Verfahren nach Anspruch 1, weiterhin umfassend die Laufzeitanpassung zwischen der Darstellungsmatrix der Tonprobe und der Darstellungsmatrix der Tonmischung.

3. Das Verfahren nach Anspruch 2, wobei die Laufzeitanpassung das Anpassen der Laufzeit mittels Spektralpeaks umfasst.

4. Das Verfahren nach einem der Ansprüche 1 bis 3, weiterhin umfassend die Verstärkungsanpassung zwischen der Darstellungsmatrix der Tonprobe und der Darstellungsmatrix der Tonmischung.

5. Das Verfahren nach einem der Ansprüche 1 bis 4, wobei die Darstellungsmatrix eine Zeit-Frequenz-Darstellungsmatrix niedriger Auflösung ist.

6. Das Verfahren nach einem der Ansprüche 1 bis 5, wobei das Vernehmbarkeitsmodell ein auf gehörrichtiger Lautstärke beruhendes Modell ist.

7. Das Verfahren nach einem der Ansprüche 1 bis 6, wobei das Vernehmbarkeitsmodell ein Fletcher-Munson-Modell ist.

8. Das Verfahren nach einem der Ansprüche 1 bis 7, weiterhin umfassend das Anwenden von einem auf psychoakustischer Maskierung beruhendes Modell auf die Tonmischung, um die Darstellungsmatrix der Tonmischung zu erzeugen.

9. Das Verfahren nach einem der Ansprüche 1 bis 8, wobei das Berechnen des Durchschnitts das berechnen des Durchschnitts in Zeitabständen umfasst, um die Vernehmbarkeit der Tonprobe in der Tonmischung in jedem Zeitabstand abzuschätzen.

10. Das Verfahren nach einem der Ansprüche 1 bis 9, weiterhin umfassend das Quantisieren der abgeschätzten Vernehmbarkeit auf eine vorbestimmte Anzahl von Vernehmbarkeitsniveaus.

11. Das Verfahren nach einem der Ansprüche 1 bis 8, wobei die Tonprobe Musik ist und die zusätzliche Tonaufnahme eine Sprachaufnahme ist.

12. Das Verfahren nach einem der Ansprüche 1 bis 11, weiterhin umfassend

bereitstellen von einem Rundfunkmedienprogramm, wobei das Rundfunkmedienprogramm die Tonmischung umfasst,
bereitstellen von einem Cuesheet, wobei das Cuesheet einen Hinweis auf die Anfangszeit und die Endzeit der Tonprobe im Rundfunkmedienprogramm umfasst.

13. Das Verfahren nach Anspruch 12, wobei die Tonmischung eine Vielzahl von Tonproben und eine zusätzliche Tonaufnahme umfasst.

14. Das Verfahren nach Anspruch 13, weiterhin umfassend das Trimmen der Tonmischung, um jede Tonprobe zu isolieren.

15. Das Verfahren nach Anspruch 14, weiterhin umfassend das Abschätzen der Vernehmbarkeit von jeder Tonprobe des Rundfunkprogramms.

**Revendications**

1. Un procédé d'estimation de l'audibilité d'un échantillon audio dans un mixage audio d'un programme de média de télédiffusion, comprenant :

fournir une matrice de représentation d'un mixage audio, le mixage audio comprenant l'échantillon audio et un audio additionnel ;
fournir une matrice de représentation de l'échantillon audio ;
soustraire la matrice de représentation de l'échantillon audio de la matrice de représentation du mixage audio afin de générer une matrice de différences ;
appliquer un modèle d'audibilité à la matrice de différences afin de générer une matrice d'audibilité ;
déterminer un niveau d'audibilité pour chaque élément de la matrice d'audibilité ;
calculer la valeur moyenne des niveaux d'audibilité déterminés de la matrice afin d'estimer l'audibilité de l'échantillon audio.

2. Le procédé selon la revendication 1, comprenant en outre l'alignement temporel entre la matrice de représentation de l'échantillon audio et la matrice de représentation du mixage audio.

3. Le procédé selon la revendication 2, dans lequel l'alignement temporel comprend effectuer l'alignement temporel en utilisant des pics spectraux.

4. Le procédé selon l'une quelconque des revendications 1 à 3, comprenant en outre l'alignement du gain entre la matrice de représentation de l'échantillon audio et la matrice de représentation du mixage audio.

5. Le procédé selon l'une quelconque des revendications 1 à 4, dans lequel la matrice de représentation est une matrice de représentation temps-fréquence à faible résolution.

6. Le procédé selon l'une quelconque des revendications 1 à 5, dans lequel le modèle d'audibilité est un modèle basé sur des lignes isosoniques.

7. Le procédé selon l'une quelconque des revendications 1 à 6, dans lequel le modèle d'audibilité est un modèle Fletcher-Munson.

8. Le procédé selon l'une quelconque des revendications 1 à 7, comprenant en outre appliquer un modèle basé sur des masques psychoacoustiques au mixage audio afin de générer la matrice de représentation du mixage audio.

9. Le procédé selon l'une quelconque des revendications 1 à 8, dans lequel le calcul de la valeur moyenne comprend calculer la moyenne en intervalles de temps afin d'estimer l'audibilité de l'échantillon audio dans le mixage audio dans chaque intervalle de temps.

10. Le procédé selon l'une quelconque des revendications 1 à 9, comprenant en outre la quantification de l'audibilité estimée à un nombre prédéterminé de niveaux d'audibilité.

11. Le procédé selon l'une quelconque des revendications 1 à 8, dans lequel l'échantillon audio est de la musique et l'audio additionnel est un enregistrement de voix.

12. Le procédé selon l'une quelconque des revendications 1 à 11, comprenant en outre :

    fournir un programme de média de télédiffusion, le programme de média de télédiffusion comprenant le mixage audio,
    fournir un *cue sheet,* le *cue sheet* comprenant une indication du temps de début et du temps de finalisation de l'échantillon audio dans le programme de média de télédiffusion.

13. Le procédé selon la revendication 12, dans lequel le mixage audio comprend une pluralité d'échantillons audio et un audio additionnel.

14. Le procédé selon la revendication 13, comprenant en outre le découpage du mixage audio afin d'isoler chaque échantillon audio.

15. Le procédé selon la revendication 14, comprenant en outre estimer l'audibilité de chaque échantillon audio du programme de télédiffusion.

Fig. 1

Fig. 2A

Fig. 2B

Fig. 3

Fig. 4

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2579247 A1